# EUROPÄISCHE PATENTSCHRIFT

(11) **EP 1 454 364 B1**
(45) Veröffentlichungstag und Bekanntmachung des Hinweises auf die Patenterteilung: **03.08.2011**
(21) Anmeldenummer: 02798316.2
(22) Anmeldetag: 22.11.2002
(51) Int. Cl.: H01L 29/868, H01L 27/06, H01L 29/417

(54) **DIODENSCHALTUNG UND VERFAHREN ZUM HERSTELLEN EINER DIODENSCHALTUNG**
DIODE CIRCUIT AND METHOD FOR MAKING SAME
CIRCUIT DE DIODE ET SON PROCEDE DE REALISATION

(30) Priorität: 11.12.2001 DE 10160829
(43) Veröffentlichungstag der Anmeldung: 08.09.2004
(73) Patentinhaber: Infineon Technologies AG, 85579 Neubiberg (DE)
(72) Erfinder: AHRENS, Carsten, 81927 München (DE); HARTUNG, Wolfgang, 81541 München (DE); HEUERMANN, Holger, 52223 Stolberg (DE); LOSEHAND, Reinhard, 80637 München (DE); SCHAFFER, Josef-Paul, 81245 München (DE)
(74) Vertreter: Zinkler, Franz
(86) Internationale Anmeldenummer: PCT/EP2002/013138
(87) Internationale Veröffentlichungsnummer: WO 2003/050885

(56) Entgegenhaltungen:
- EP-A- 0 054 648
- EP-A- 1 146 567
- EP-A- 1 160 850
- WO-A-01/17032
- FR-A- 2 559 959
- US-A- 5 798 560
- US-A1- 2001 045 617
- BERGER H H ET AL: "METHOD OF PRODUCING TRANSISTORS WITH OPTIMUM BASE CONTACT" IBM TECHNICAL DISCLOSURE BULLETIN, IBM CORP. NEW YORK, US, Bd. 23, Nr. 4, September 1980 (1980-09), Seiten 1487-1488, XP000806083 ISSN: 0018-8689
- ZURCHER P ET AL: "INTEGRATION OF THIN FILM MIM CAPACITORS AND RESISTORS INTO COPPER METALLIZATION BASED RF-CMOS AND BI-CMOS TECHNOLOGIES" INTERNATIONAL ELECTRON DEVICES MEETING 2000. IEDM. TECHNICAL DIGEST. SAN FRANCISCO, CA, DEC. 10 - 13, 2000, NEW YORK, NY: IEEE, US, 10. Dezember 2000 (2000-12-10), Seiten 153-156, XP000988822 ISBN: 0-7803-6439-2

## Beschreibung

Die vorliegende Erfindung bezieht sich auf Diodenschaltungen und insbesondere auf integrierte Diodenschaltungen.

Die EP 1146567 A1 offenbart eine Diode und ein Verfahren zu deren Herstellung. Die Diode ist als pin-Diode ausgeführt und umfaßt ein hochdotiertes n-leitendes Siliziumsubstrat, auf dem ein gering dotiertes n-leitendes Gebiet aufgebracht ist. Auf dem schwach dotierten n-leitenden Gebiet ist wieder ein hochdotiertes p-leitendes Gebiet angeordnet. Das schwach dotierte Gebiet ist durch Epitaxie auf dem hochdotierten Siliziumsubstrat hergestellt, wobei das hochdotierte p-leitende Gebiet durch Implantation in dem Epitaxie-Gebiet erzeugt wird. Die pin-Diode, die in der Draufsicht kreisförmig ausgebildet ist, umfaßt einen Isolationsgraben, der sich um die aktive Diodenstruktur herum erstreckt und diese eingrenzt. Die Diode wird dadurch kontaktiert, daß auf dem hochdotierten p-leitenden Gebiet eine Elektrode angebracht wird, und daß, nach einer rückseitigen Dünnung, auf der rückseitigen Oberfläche des stark dotierten n-leitenden Siliziumsubstrats ein Rückseitenkontakt aufgebracht wird. Durch Bereitstellen des Isolationsgrabens ist die Ausdehnung des Verarmungsgebiets und damit die Flächenkapazität der Diode von der Größe der oberen Elektrode entkoppelt, so daß die Ausdehnung des Verarmungsgebiets unabhängig von der Größe der Elektrode gewählt werden kann. Dies ermöglicht geringe Ein/Aus-Schaltzeiten, die insbesondere dann erforderlich sind, wenn die pin-Diode als Hochfrequenz-Schalter verwendet wird.

Zum Einbau einer solchen Diode in einer Schaltung muß dieselbe mit einem externen HF-Einkopplungs-Netzwerk und ferner mit einem Bias-Zuführungsnetzwerk versehen werden, damit dieselbe in einer Hochfrequenz-Schaltung verwendet werden kann. Die Halbleiter-Diode muß daher mit einem Hochpaß für die HF-Einkopplung, einem Hochpaß für die HF-Auskopplung und einem Tiefpaß für die Bias-Zuführung extern beschaltet werden.

Nachteilig an diesem Konzept ist die Tatsache, daß der Platzverbrauch relativ hoch ist. Darüber hinaus sind aufwendige und damit teuere Verarbeitungsschritte erforderlich, um eine Kontaktierung der externen Beschaltung beispielsweise durch Bonden zu erhalten. Ferner führt die externe Beschaltung unter Verwendung von Bonddrähten dazu, daß zusätzliche parasitäre Effekte, von denen besonders die Induktivitäten der Bonddrähte problematisch sind, eingeführt werden, die zum einen schlecht simuliert und daher im Schaltungsdesign berücksichtigt werden können, und die zum anderen die Grenzfrequenz der Gesamtschaltung vermindern.

Die FR 2559959 offenbart eine Hochfrequenzdiode mit externen Verbindungen, die in einem Substrat realisiert ist, und die einen kleinen kreisförmigen p⁺-Kontaktbereich und einen diesen Kontaktbereich in einer bestimmten Beabstandung teilweise umgreifenden n⁺-Kontaktbereich hat, wobei in dem n⁺-Kontaktbereich die hintere Schicht sowie die p⁺-Schicht nicht vorhanden sind.

Die Fachveröffentlichung von Berger u.a., "Method of Producing Transistors with Optimum Base Contact", IBM Technical Disclosure Bulletin, IBM Corp, New York, Band 23, Nr. 4, September 1980, Seiten 1487 bis 1488 offenbart einen Transistor, der gemäß dem Kollektor-difundierten Isolationsprinzip hergestellt ist, bei dem eine direkte Kontaktierung der aktiven intrinsischen Basisregion vorhanden ist.

Die Aufgabe der vorliegenden Erfindung besteht darin, eine Diodenschaltung und ein Verfahren zum Herstellen einer Diodenschaltung zu schaffen, welche preisgünstiger und im Platzverbrauch besser sind.

Diese Aufgabe wird durch eine Diodenschaltung nach Patentanspruch 1 oder durch ein Verfahren zum Herstellen einer Diodenschaltung nach Patentanspruch 14 gelöst.

Der vorliegenden Erfindung liegt die Erkenntnis zugrunde, daß eine bessere und preisgünstigere Schaltung dadurch erreicht werden kann, wenn die Diode samt Versorgungsnetzwerk miteinander integriert werden. Dies wird erfindungsgemäß dadurch möglich, daß eine pin-Diode hergestellt wird, deren Elektroden zur Kontaktierung des hochdotierten n-Bereichs und zur Kontaktierung des hochdotierten p-Bereichs auf derselben Oberfläche des Halbleiter-Substrats angeordnet sind. Dies wird dadurch erreicht, daß entweder der p-Bereich oder der n-Bereich als "Buried-Layer" ausgeführt werden. Die Konfiguration, bei der beide Anschlüsse für die Diode auf derselben Hauptoberfläche des Halbleitersubstrats angeordnet sind, ermöglicht es, weitere Schaltungen, wie z. B. einen Kondensator, einen Widerstand oder eine Spule, mit der Diode zu integrieren.

Um eine Integration der Diode und eines Kondensators zu ermöglichen, wird die Diode auf einem hochohmigen Schaltungssubstrat aufgebaut.

Bei einem bevorzugten Ausführungsbeispiel wird die Buried-Layer durch Implantation in dem hochohmigen Substrat erzeugt. Die i-Schicht wird durch Epitaxieverfahren auf der Buried-Layer aufgewachsen. Das hochdotierte p-Gebiet wird durch Dotierung eines oberen Bereichs der Epitaxieschicht hergestellt. Die Kontaktierung für die vergrabene Schicht wird unter Verwendung eines Grabens hergestellt. Mit dieser Grabenätzung kann neben der Kontaktierung der vergrabenen Schicht auch ein Isolationsgraben zur Plasmaeingrenzung der pin-Diode sowie ein integrierter Kondensator in demselben Substrat erzeugt werden. Wenn neben dem Graben zur Kontaktierung der vergrabenen Schicht ein Isolationsgraben und ein Trench-Kondensator hergestellt werden, wird durch den Graben zunächst der Bereich der Epitaxieschicht um den Graben herum dotiert (außer im Bereich des Isolationsgrabens). Dann wird die Oberfläche des Grabens mit einer Isolationsschicht versehen, um das Kondensator-Dielektrikum zu erhalten. Dies führt dazu, daß auch der bzw. die Kontaktierungsgräben für die vergrabene Schicht isoliert werden. Der Stromtransport findet dann nicht durch die anschließend mit leitfähigem Material aufgefüllten Gräben statt, sondern durch den um die Kontaktierungsgräben herum dotierten Bereich statt. Die mit leitfähigem Material gefüllten Gräben zur Kontaktierung der vergrabenen Schicht sind dann für den Stromtransport nicht geeignet, da sie isoliert sind. Es hat sich jedoch herausgestellt, daß der Stromtransport über die Umgebung der Gräben ausreichend ist. Daher müssen keine weiteren Schritte unternommen werden, um aus den "Kontaktierungsgräben" das Kondensator-Dielektrikum wieder herauszuholen.

Bei einem weiteren bevorzugten Ausführungsbeispiel der vorliegenden Erfindung wird ferner ein integrierter Widerstand hergestellt, der durch eine Schicht aus demselben Material gebildet wird, mit dem die Gräben des integrierten Kondensators nach Dotierung und Isolation aufgefüllt werden. Eine Verdrahtung kann mittels einer Metallisierungslage erfolgen. Auf der Metallisierungslage kann ferner, wenn mehrere Metallisierungslagen vorhanden sind, ein integrierter Induktor erzeugt werden, der ebenfalls durch mit Metall gefüllte Via-Löcher mit der Diode, dem Kondensator und dem Widerstand nach Bedarf verschaltet werden kann.

Bevorzugte Ausführungsbeispiele der vorliegenden Erfindung werden nachfolgend Bezug nehmend auf die beiliegenden Zeichnungen detailliert erläutert. Es zeigen:
- Fig. 1: eine Schnittansicht durch eine integrierte Schal- tung mit einer pin-Diode, einem integrierten Kon- densator, einem integrierten Widerstand, und einem integrierten Induktor; und
- Fig. 2: ein Schaltbild zur Darstellung einer bevorzugten integrierten Beschaltung der Diode mit passiven E- lementen, die über die Metallisierungsstruktur von Fig. 1 erzielt werden kann.

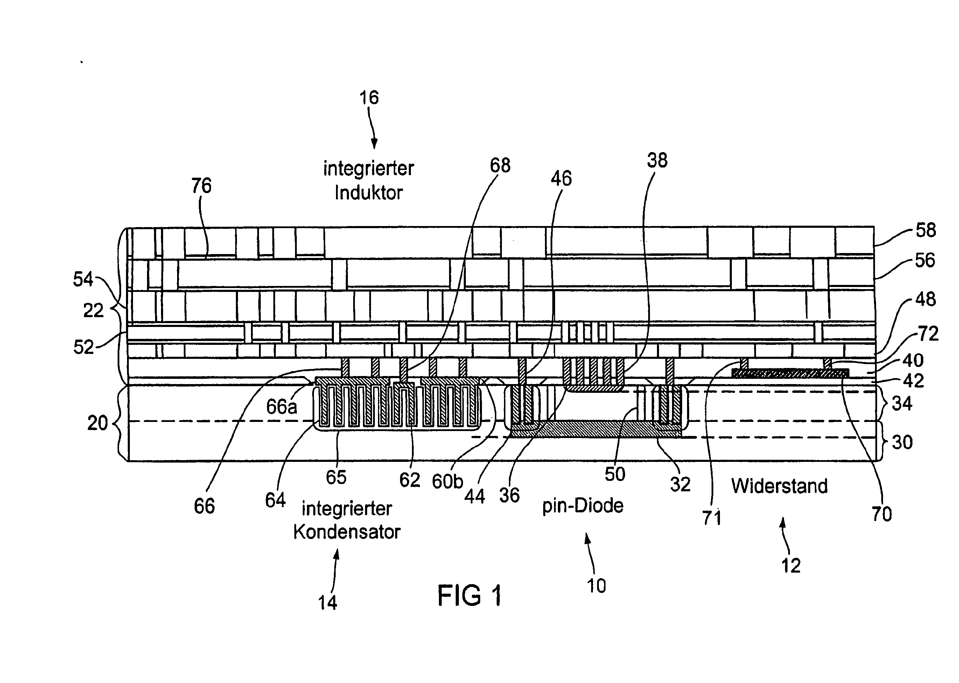

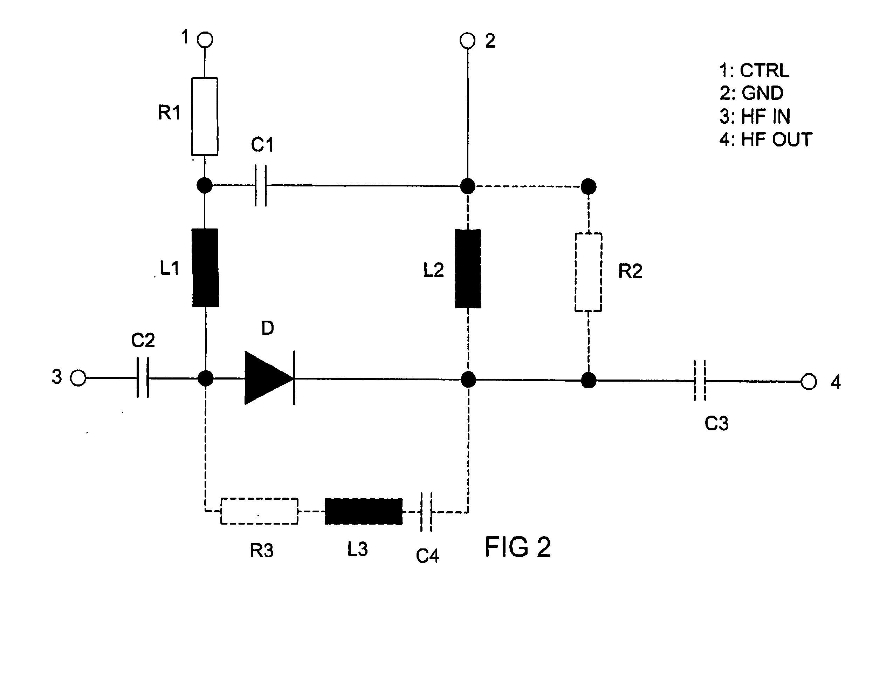

Bevor detailliert auf die Fig. 1 und 2 eingegangen wird, wird zunächst auf die allgemeine Funktionsweise einer pin-Diode Bezug genommen. Typischerweise umfaßt eine pin-Diode ein schwach dotiertes oder nicht dotiertes intrinsisches Gebiet auf. Dieses intrinsische Gebiet hat typischerweise eine im Vergleich zu dem p- und n-dotierten Gebiet eine große Ausdehnung. Wenn eine Sperrspannung an die pin-Diode angelegt wird, ist das i-Gebiet sehr schnell von allen freien Ladungsträgern ausgeräumt, und die Raumladungszone erstreckt sich durch das gesamte i-Gebiet. Dies führt dazu, daß eine pin-Diode in Sperrichtung eine sehr niedrige Sperrkapazität hat, die im Bereich zwischen 200 und 300 fF liegen kann.

Wird die pin-Diode dagegen in Flußrichtung gepolt, so wird das i-Gebiet mit Ladungsträgern überschwemmt, und die Diffusionskapazität zwischen dem p-Gebiet und dem i-Gebiet ist sehr groß. Ferner ist der Ohmsche Widerstand der Diode sehr niedrig, da das i-Gebiet von freien Ladungsträgern überschwemmt wird.

Die pin-Diode kann daher als gesteuerter Widerstand aufgefaßt werden, wobei der gesteuerte Widerstand in Flußrichtung einen kleinen Wert hat, und wobei ferner die Kapazität in Flußrichtung sehr groß ist. Für ein Hochfrequenz-Signal, das an der pin-Diode anliegt, bedeutet dies, daß es aufgrund des kleinen Ohmschen Widerstands eine geringe Dämpfung erfährt und daß die hohe Diffusionskapazität einen Kurzschluß für das Hochfrequenzsignal darstellt. Für eine Polung in Sperrichtung der pin-Diode sieht das Hochfrequenzsignal dagegen einen sehr hohen Ohmschen Widerstand und eine sehr geringe Serienkapazität. Die pin-Diode stellt daher einen Hochfrequenz-Schalter dar, der geschlossen ist, wenn die Diode in Flußrichtung gepolt ist, und der offen ist, wenn die Diode in Sperrichtung gepolt ist.

Im nachfolgenden wird anhand von Fig. 1 auf die erfindungsgemäße pin-Diode samt Beschaltung mit passiven Elementen Bezug genommen. Fig. 1 zeigt einen Querschnitt durch ein Halbleiter-Substrat mit einer pin-Diode 10, einem integrierten Widerstand 12, einem integrierten Kondensator 14 und einem integrierten Induktor 16. In der Draufsicht könnte die pin-Diode beispielsweise kreisförmig oder rechteckig ausgeführt sein. Dies gilt prinzipiell auch für den Widerstand, den integrierten Kondensator und den integrierten Induktor, wobei aus Einfachheitsgründen für den integrierten Widerstand eine in der Draufsicht rechteckige Form gewählt wird.

Die in Fig. 1 gezeigte integrierte Schaltung setzt sich aus einem Halbleiter-Substrat 20 und einer Metallisierungsstruktur 22 zusammen, wobei die Metallisierungsstruktur 22 nach der Fertigstellung des Halbleitersubstrats 20 auf demselben aufgebracht wird. Das Halbleiter-Substrat 20 wird hergestellt, indem ein Grund-Halbleiter-Substrat 30 bereitgestellt wird. In dem Grund-Halbleiter-Substrat 30 wird dann eine Schicht 32 beispielsweise durch Implantation gebildet, die später - nach der Epitaxie. - als vergrabene Schicht fungiert. Die vergrabene Schicht 32 ist bei dem bevorzugten Ausführungsbeispiel der vorliegenden Erfindung eine stark n-dotierte Schicht. Wie es aus Fig. 1 ersichtlich ist, ist die stark n-dotierte Schicht auf den Bereich der pin-Diode 10 begrenzt. Unter dem integrierten Kondensator 14 und dem integrierten Widerstand 12 und dem integrierten Induktor befindet sich keine solche vergrabene Schicht 32. Es sei darauf hingewiesen, daß das Grundhalbleiter-Substrat 30 vorzugsweise ein hochohmiges Substrat ist, so daß beispielsweise der integrierte Kondensator 14 von der integrierten pin-Diode 10 gewissermaßen automatisch isoliert ist. Die Erzeugung einer hochdotierten Schicht 32 in einem Bereich der Oberflächen des Grund-Halbleitersubstrats 30 kann beispielsweise durch photolithographische Techniken und Ionenimplantation beispielsweise durch Ionendiffusion erzeugt werden.

Auf der vergrabenen Schicht 32, die eine zweite Halbleiter-Schicht mit einem zweiten Dotierungstyp n bildet, wird mittels epitaxialer Verfahren eine dritte Halbleiter-Schicht 34 aufgewachsen, die schwach n dotiert oder sogar intrinsisch ist, d. h. deren Dotierungskonzentration typischerweise um einige Größenordnungen kleiner ist als die Dotierungskonzentration der vergrabenen Schicht 32 und natürlich auch als die Dotierungskonzentration einer ersten Halbleiter-Schicht 36. Die erste Halbleiter-Schicht 36, die typischerweise stark p dotiert ist, wird durch Dotierung eines örtlich eingegrenzten Bereichs in der zweiten Halbleiter-Schicht 34 erzeugt. Die pin-Diode besteht somit aus einer p-Schicht 36, gefolgt von einer i-Schicht 34, wieder gefolgt von einer n-Schicht 32 in dem Halbleiter-Substrat 20. Die erste Halbleiter-Schicht 36, die bei dem in Fig. 1 gezeigten bevorzugten Ausführungsbeispiel p-dotiert ist, wird durch eine erste Kontaktierung 38 kontaktiert. Die erste Kontaktierung 38 umfaßt mit Wolfram gefüllte Durchgangslöcher durch eine erste Isolatorschicht 40 und eine zweite Isolatorschicht 42.

Die vergrabenen Schicht 32 wird mittels einer zweiten Kontaktierung kontaktiert, die einen in der zweiten Halbleiter-Schicht 34 dotierten Bereich 44 umfaßt, auf den später eingegangen wird. Die zweite Kontaktierung umfaßt ferner ebenfalls ein mit einem Wolfram-Material gefülltes Durchgangsloch 46, das, ebenso wie die erste Kontaktierung 38 mittels einer Verdrahtungsebene 48 mit anderen Elementen verdrahtet werden kann. Die freigelassenen Bereich der Verdrahtungsebene 48 sollen beispielsweise Kupfer-Bereiche umfassen, während die schraffiert in Fig. 1 gezeigten Bereiche eine Isolatorschicht symbolisieren sollen. Die pin-Diode umfaßt ferner bei einem bevorzugten Ausführungsbeispiel der vorliegenden Erfindung einen sich um den aktiven i-Bereich herum erstreckenden Isolationsgraben 50, der eine Ladungsträgereingrenzung bei in Flußrichtung gepolter pin-Diode ermöglicht und somit, wie es in der EP 1146567 A1 beschrieben ist, zu kurzen Ein/AusSchaltzeiten führt.

Die in Fig. 1 gezeigte Metallisierungsstruktur 22 umfaßt ferner, neben der Querverdrahtungsebene 48, die auch als erste Metallisierungsebene bezeichnet wird, eine erste Via-Ebene 52, eine zweite Metallisierungsebene 54, eine zweite Via-Ebene 56 sowie eine dritte Metallisierungsebene 58. Die Ebene, die durch die Schichten 40 und 42 gebildet wird, wird auch als Wolfram-Ebene bezeichnet, da in derselben die Wolfram-Plugs der ersten und der zweiten Kontaktierung gebildet sind.

Bei einem bevorzugten Ausführungsbeispiel der vorliegenden Erfindung werden folgende vertikalen Abmessungen für die einzelnen Ebenen bevorzugt. Die Metallisierungsebene M1 (48) hat typischerweise eine Ausdehnung von 600 nm. Die erste Via-Ebene 52 hat typischerweise eine Ausdehnung von 900 nm. Die zweite Metallisierungsebene M2 (54) hat typischerweise eine Ausdehnung von 2,5 µm. Die zweite Via-Ebene 56 hat typischerweise eine Ausdehnung von 1 bis 2 µm. Die dritte Metallisierungsebene M3 (58) hat typischerweise eine Ausdehnung von 2,5 µm.

Im nachfolgenden wird auf den integrierten Kondensator eingegangen. Der integrierte Kondensator umfaßt eine erste Kondensatorelektrode 60a, 60b und eine zweite Kondensatorelektrode 62. Das Kondensator-Dielektrikum wird durch eine Isolatorschicht 64 gebildet. Die erste Kondensatorelektrode 60a/60b wird durch einen oder mehrere Wolfram-Plugs 66 mit der Querverdrahtungsebene 48 verbunden. Dasselbe trifft für die zweite Kondensatorelektrode 62 zu, die ebenfalls durch einen Wolfram-Plug 68 mit der Querverdrahtungsebene 48 in Verbindung gebracht wird.

Die erste Kondensatorelektrode 60a/60b umfaßt mit leitfähigem Material, wie z. B. hochdotiertem n⁺-Polysilizium, gefüllte Gräben. Diese sind durch die Isolatorschicht 64 von einem die Gräben umgebenden hochdotierten Bereich 65 in der Epitaxieschicht 34 umgeben, wobei dieser hochdotierte Bereich 65 gewissermaßen die zweite Kondensatorelektrode bildet. Die Gräben 62 dienen hierbei nicht zum Stromtransport, sondern die Bereiche um die Gräben 62 herum, die mit dem Wolfram-Plug 68 in elektrisch leitfähiger Verbindung sind. Die Gräben 62 sind daher sogenannte Dummy-Gräben, die selber nicht mehr zum Stromtransport beitragen, da sie von dem umgebenden leitfähigen Bereich 65 durch die Isolatorschicht 64 elektrisch isoliert sind, die jedoch zum Erzeugen des hochdotierten Bereichs 65 benötigt werden. Hierbei wird gewissermaßen dasselbe Prinzip wie bei der zweiten Kontaktierung der vergrabenen Schicht der pin-Diode ausgenutzt, bei dem ebenso die Gräben zwar zur Erzeugung des leitfähigen Bereichs 44 erforderlich sind, jedoch dann, wenn die Schaltung fertiggestellt ist, nicht selbst zum Stromtransport verwendet werden können, da es bei dem bevorzugten Ausführungsbeispiel der vorliegenden Erfindung zu aufwendig wäre, das Isolationsmaterial aus den Gräben, das als Kondensator-Dielektrikum fungiert, zu entfernen, obwohl dies grundsätzlich durchgeführt werden könnte.

Der integrierte Induktor 16 wird typischerweise in den Metallisierungsebenen M3 (58) und/oder M2 (54) gebildet und ist typischerweise spiralförmig aufgebaut. Er kann sich entweder in einer Metallisierungsebene erstrecken, wobei beide Anschlüsse durch Via-Löcher auf die Verdrahtungs-Ebene 48 gezogen werden können. Der Induktor kann ferner auch in zwei Metallisierungsebenen angeordnet sein, wobei der innere Anschluß der Spirale beispielsweise über die Via-Ebene 56 von der dritten Metallisierungsebene 58 auf die zweite Metallisierungsebene 54 heruntergezogen werden kann, um eine sogenannte Bridge zu vermeiden, die bei einem Induktor erforderlich ist, der in einer einzigen Metallisierungsebene angeordnet ist und nur einseitig kontaktierbar ist.

Der integrierte Widerstand umfaßt einen Widerstanddefinierenden Bereich 70 sowie einen ersten Anschluß 71 und einen zweiten Anschluß 72. Der den Widerstand-definierende Bereich 70 wird auf der unteren Isolationsschicht 42 definiert und durch die Wolfram-Plugs 71 und 72 auf die Verdrahtungsebene 48 gezogen. Das Material des Bereichs 70 ist vorzugsweise dasselbe Material wie es in die Gräben des integrierten Kondensators und der pin-Diode bzw. der Kontaktierung der vergrabenen Schicht der pin-Diode gefüllt wird.

Im nachfolgenden wird auf die Herstellung der in Fig. 1 gezeigten Schaltung gemäß einem bevorzugten Ausführungsbeispiel der vorliegenden Erfindung Bezug genommen.

Zunächst wird ein hochohmiges Grund-Halbleiter-Substrat30 bereitgestellt, in das dann die örtlich begrenzte vergrabene Schicht 32 durch n-Dotierung hergestellt wird. Dann wird auf dem gesamten Grund-Halbleitersubstrat, d. h. auf der vergrabenen Schicht und in den Nebenbereichen, wo das Grund-Halbleiter-Substrat nicht stark dotiert ist, die niederohmige Epitaxieschicht 34 aufgewachsen. Hierauf wird die erste stark p-dotierte Halbleiter-Schicht 36 in der Epitaxieschicht gebildet, woraufhin dann die gesamte nun vorhandene Oberfläche des Halbleiter-Substrats 20 mit der Isolatorschicht 42 versehen wird. In den Bereichen, wo eine Grabenätzung für die erste Kontaktierung, die zweite Kontaktierung und den Kondensator erfolgen soll, wird die Isolatorschicht 42 entfernt. Dann wird eine Grabenätzung durchgeführt, wobei sich die Gräben zumindest teilweise durch die dritte Halbleiter-Schicht 34, also die Epitaxieschicht erstrecken. Werden Isolationsgräben 50 verwendet, so müssen sich die Gräben durch die gesamte Epitaxieschicht 34 erstrecken. Werden keine Isolationsgräben 50 verwendet, so müssen sich die Gräben so weit durch die Epitaxieschicht erstrecken, daß der durch die Gräben dotierte Bereich die vergrabene Schicht 32 "erreicht".

Nach einer Ätzung der Gräben sowohl für die Kontaktierung der vergrabenen Schicht 32 als auch für die Kondensatorstruktur wird vorzugsweise eine PoCl-Diffusion verwendet, um die Bereiche 65 und 44 um die Gräben herum hoch zu dotieren. Nach abgeschlossener Dotierung wird in den Bereichen, wo Gräben vorhanden sind, eine Isolatorschicht abgeschieden, die als Kondensator-Dielektrikum wirkt. Diese Isolatorschicht wird ferner ebenfalls in den Gräben der zweiten Kontaktierung 44 eingebracht, da diese Gräben sonst abgedeckt werden müßten, was zu weiteren aufwendigen und teueren Schritten führen würde. Dann, nach einer Aufbringung der Isolatorschicht 64 werden die Gräben mit leitfähigem Material gefüllt. In diesem Schritt wird ferner der Bereich 70 des Widerstands 12 hergestellt, der aus dem gleichen Material besteht, wie es in den Gräben zu finden ist. Als Material wird hierbei n⁺-dotiertes Polysilizium bevorzugt. Danach wird über der gesamten sich ergebenden Struktur die zweite Isolatorschicht 44 aufgebracht. Dann werden in dieser Schicht die Durchgangslöcher für die Wolfram-Plugs definiert, hergestellt und mit Wolfram aufgefüllt. Daran anschließend werden die weiteren Schichten 48, 52, 54, 56 und 58 hergestellt, indem zwischen den Schichten immer eine dünne Isolatorschicht (z. B. 76) erzeugt wird, auf der dann eine dicke Isolatorschicht aufgebracht wird, in der die gewünschten Metallstrukturen für die Durchgangsloch-Kontaktierung, den integrierten Induktor oder die Verdrahtungsebene erzeugt werden.

Fig. 1 zeigt lediglich eine prinzipielle Anordnung von Diode, Kondensator, Widerstand und Spule (Induktor) in einer integrierten Schaltung, ohne daß die einzelnen Elemente miteinander verschaltet sind. Die Verschaltung der Elemente findet vorzugsweise in der Verdrahtungsebene 48 statt, kann jedoch auch in jeder anderen Ebene, die über der Verdrahtungsebene 48 angeordnet ist, erfolgen. Der HF-Eingang, der HF-Ausgang, der Steuer-Eingang sowie der Steuer-Ausgang (die Schaltungsmasse) werden typischerweise in der dritten Metallisierungs-ebene 58 realisiert, da dieselbe nach außen verfügbar ist. Bildet die in Fig. 1 gezeigte integrierte pin-Diode dagegen Teil einer größeren Schaltung, so können die Ein/Ausgänge auch auf einer anderen Ebene realisiert werden, da sie von benachbarten Komponenten innerhalb der Metallisierungsstruktur 22 angesteuert werden.

Im nachfolgenden wird anhand von Fig. 2 auf eine bevorzugte Ausführungsform für eine passive Beschaltung Bezug genommen. Ein Eingang, der mit "1" bezeichnet ist, stellt einen Steuer-eingang (CTRL) zum Anlegen einer Versorgungsspannung für die Diode dar. Ein zweiter Eingang, der in Fig. 2 mit "2" bezeichnet ist, stellt den Masse-Eingang (GND) dar. Ein dritter Eingang, der in Fig. 2 mit "3" bezeichnet ist, ist dafür vorgesehen, ein Hochfrequenz-Eingangssignal (HF IN) einzuspeisen. Das HF-Ausgangssignal (HF OUT) kann an einem Ausgang, der in Fig. 2 mit "4" bezeichnet ist, ausgegeben werden.

Ein Widerstand R1 ist vorgesehen, um eine an dem Eingang "1" angelegte Spannung in einen Versorgungsstrom für die Diode D umzuwandeln. Eine Kapazität C1 sowie eine Induktivität L1 bilden einen Tiefpaß für den Dioden-Versorgungsstrom. Die Gleichstrom-Entkopplung des Eingangs 3 findet mit einem Kondensator C2 statt. Ferner wird es bevorzugt, eine weitere Spule L2 zwischen einem Ausgang der Diode D und Masse vorzusehen, um einen Gleichstrom-Rückweg zu ermöglichen, wenn der Gleichstrom-Rückweg nicht über den Ausgang 4 der Schaltung erfolgen soll. In diesem Fall kann ferner eine Serien-Kapazität C3 zwischen Ausgang 4 und Kathode (d. h. vergrabene n-Schicht) vorgesehen sein. Ein weiterer Widerstand R2 dient ferner vorzugsweise dazu, eine Ableitung von in der Diode gespeicherten Ladungen gegen Masse zu ermöglichen, wodurch Ausschaltzeiten verbessert werden können.

Ferner wird es bevorzugt, parallel zu der Diode D eine Induktivität L3 zu schalten, die so dimensioniert ist, daß sie mit einer Sperrkapazität der Diode D, wenn dieselbe in Sperrichtung betrieben, also negativ vorgespannt ist, einen Parallelresonanzkreis zu bilden, und zwar mit einer Resonanzfrequenz, die gleich der mittleren Betriebsfrequenz des an dem Eingang 3 anliegenden HF-Signals ist. Damit kann das Sperrverhalten der Diode, d. h. die Impedanz der Diode in Sperrichtung erhöht werden, da der Parallelresonanzkreis in Resonanz einen theoretisch unendlichen hohen Widerstand hat. Als weitere Design-Parameter können ferner ein Widerstand R3 sowie ein Kondensator C4 eingesetzt werden, um parasitäre Elemente der Spule L3 zu berücksichtigen, oder um allgemein unter Berücksichtigung sämtlicher anderer Elemente in der in Fig. 2 gezeigten Schaltung einen möglichst kleinen Vorwärtsübertragungsparameter vom HF-Eingang 3 zum HF-Ausgang 4 zu erhalten, wenn die Diode in Sperrichtung betrieben ist, d. h. wenn der erfindungsgemäße integrierte pin-Schalter offen ist.

Die in Fig. 2 gezeigten diskreten Elemente können mit der in Fig. 1 dargestellten Technologie auf einem einzigen Halbleiter-Substrat realisiert und gemäß dem in Fig. 2 gezeigten Schaltplan miteinander verschaltet werden, um eine integrierte Dioden-Schaltung mit HF-Einkopplungsnetzwerk, HF-Auskopplungsnetzwerk und Bias-Netzwerk zu erhalten.

Das erfindungsgemäße Konzept ist dahingehend vorteilhaft, daß getrennte Ein/Ausgänge für HF- und DC-Bias vorgesehen werden, daß durch die erfindungsgemäße monolithische Integration eine Platzeinsparung ermöglicht wird, und daß ferner durch die monolithische Integration die Schaltung preiswerter und mit weniger parasitären Effekten hergestellt werden kann, als wenn die Diodenbeschaltung mittels externer Elemente erfolgt.

Dies wird dadurch ermöglicht, daß die pin-Diode eine laterale Kontaktanordnung durch Kontaktierung einer vergrabenen Schicht umfaßt, und daß der integrierte Kondensator und der integrierte Widerstand in den Herstellungsprozeß der pin-Diode integriert werden können, und daß ferner ein hochohmiges Substrat eingesetzt werden kann, so daß auch integrierte Induktoren mit hoher Güte erzeugt werden können, da keine größeren Wirbelstromverluste wie bei einem niederohmigen Substrat auftreten.

An dieser Stelle sei darauf hingewiesen, daß Spulen mit hoher Güte insbesondere dann erreicht werden, wenn, entgegen der Darstellung in Fig. 1, unterhalb der Induktivität möglichst wenig Metallisierungsstrukturen und insbesondere kein niederohmiger Bereich eines Kondensators vorhanden ist.

### Bezugszeichenliste

- 1: Steuereingang
- 2: Masseeingang
- 3: HF-Eingang
- 4: HF-Ausgang
- R1: integrierter Widerstand
- R2: integrierter Widerstand
- R3: integrierter Widerstand
- C1: integrierter Kondensator
- C2: integrierter Kondensator
- C3: integrierter Kondensator
- C4: integrierter Kondensator
- L1: integrierte Spule
- L2: integrierte Spule
- L3: integrierte Spule
- 10: pin-Diode
- 12: integrierter Widerstand
- 14: integrierter Kondensator
- 16: integrierter Induktor
- 20: Halbleiter-Substrat
- 22: Metallisierungsstruktur
- 30: Grund-Halbleitersubstrat
- 32: n-Halbleiterschicht
- 34: i-Halbleiterschicht
- 36: p-Halbleiterschicht
- 38: Wolfram-Plug für die p-Halbleiterschicht
- 40: Isolationsschicht
- 42: Isolationsschicht
- 44: leitendes Gebiet der zweiten Kontaktierung
- 46: Wolfram-Plug für die zweite Kontaktierung
- 48: Verdrahtungsebene
- 50: Isolationsgraben
- 52: Via-Ebene
- 54: zweite Metallisierungsebene
- 56: zweite Via-Ebene
- 58: dritte Metallisierungs-Ebene
- 60a, 60b: erste Kondensatorelektrode
- 62: zweite Kondensatorelektrode
- 64: Kondensator-Dielektrikum
- 65: dotierter Kondensator-Elektrodenbereich
- 66: Wolfram-Plug
- 68: Wolfram-Plug
- 70: Bereich mit definiertem Widerstand
- 71: erste Elektrode des Widerstands
- 72: zweite Elektrode des Widerstands
- 76: dünne Isolationsschicht

## Patentansprüche

1. Diodenschaltung mit folgenden Merkmalen:
einem Halbleiter-Substrat mit einer Hauptoberfläche, wobei das Halbleiter-Substrat folgende Merkmale aufweist:
eine erste Halbleiter-Schicht (36) mit einem ersten Dotierungstyp (p);
eine zweite Halbleiter-Schicht (32) mit einem zweiten Dotierungstyp (n), und
eine dritte Halbleiter-Schicht (34), die zwischen der ersten und der zweiten Halbleiter-Schicht angeordnet ist, und deren Konzentration an freien Ladungsträgern kleiner als eine Konzentration an freien Ladungsträgern der ersten und der zweiten Halbleiter-Schicht ist,
wobei die zweite Halbleiter-Schicht (32) eine in dem Halbleiter-Substrat (20) vergrabene Schicht ist,
wobei die erste Halbleiter-Schicht (36) an der Hauptoberfläche des Halbleiter-Substrats (20) angeordnet ist;
wobei ein Graben in der dritten Halbleiter-Schicht (34) vorhanden ist, der sich von der Hauptoberfläche des Halbleiter-Substrats zumindest teilweise bis zu der zweiten Halbleiter-Schicht (32) erstreckt,
einer ersten Kontaktierung (38) zum Kontaktieren der ersten Halbleiter-Schicht (36), die an der Hauptoberfläche des Halbleiter-Substrats angeordnet ist; und
einer zweiten Kontaktierung (44, 46) zum Kontaktieren der zweiten Halbleiter-Schicht (32), wobei sich die zweite Kontaktierung von der Hauptoberfläche des Halbleiter--Substrats (20) bis zu der zweiten Halbleiter-Schicht (32) erstreckt,
wobei die zweite Kontaktierung (44, 46) einen in der dritten Halbleiter-Schicht (34) gelegenen stark-dotierten Bereich (44) umfasst, der räumlich um den Graben in der dritten Halbleiter-Schicht (34) herum angeordnet ist, und
wobei der Graben von dem stark dotierten Bereich (44) durch eine Isolatorschicht (64) isoliert ist.

2. Diodenschaltung nach Anspruch 1, die ferner folgendes Merkmal aufweist:
einen Isolationsgraben (50), der sich von der Hauptoberfläche des Halbleiter-Substrats bis zu der vergrabenen Schicht (32) erstreckt und die erste Halbleiter-Schicht (36), die an der Hauptoberfläche des Halbleiter-Substrats angeordnet ist, im wesentlichen umgibt;
wobei die zweite Kontaktierung (44, 46) außerhalb des Isolationsgrabens (50) angeordnet ist und sich durch die zweite Halbleiter-Schicht (34) erstreckt.

3. Diodenschaltung nach einem der vorhergehenden Ansprüche, die ferner einen in dem Halbleiter-Substrat integrierten Kondensator aufweist, der eine erste Elektrode (60a, 60b) und eine zweite Elektrode (62) aufweist, die beide an der Hauptoberfläche des Halbleiter-Substrats (20) angeordnet sind.

4. Diodenschaltung nach Anspruch 3, beider der Kondensator ferner folgende Merkmale aufweist:
einen weiteren Graben in der dritten Halbleiter-Schicht (34);
einen dotierten Bereich (65) in der dritten Halbleiter-Schicht (34), der um den weiteren Graben herum angeordnet ist;
eine Isolatorschicht (64) in dem weiteren Graben;
ein leitfähiges Material auf der Isolationsschicht in dem Graben,
wobei die erste Elektrode mit dem leitfähigen Material in dem weiteren Graben verbunden ist, und
wobei die zweite Elektrode mit dem dotierten Bereich (65), der um den weiteren Graben herum angeordnet ist, verbunden ist.

5. Diodenschaltung nach einem der Ansprüche 1 bis 4,
die ferner einen integrierten Widerstand (70) aufweist, der von dem Halbleiter-Substrat (20) durch eine Isolatorschicht (42) auf der Hauptoberfläche des Halbleiter-Substrats getrennt ist, und der einen Bereich (70) aus einem elektrisch leitfähigen Material aufweist.

6. Diodenschaltung nach Anspruch 5, wobei der Bereich aus elektrisch leitfähigem Material ein Material aufweist, das dasselbe ist, wie ein Material in einem Graben eines Kondensators, der in der dritten Halbleiter-Schicht (34) vorgesehen ist, oder wie ein Material in einem Graben, der für die zweite Kontaktierung verwendet ist.

7. Diodenschaltung nach einem der vorhergehenden Ansprüche, die ferner einen integrierten Induktor (16) aufweist, der von dem Halbleiter-Substrat durch zumindest eine Isolatorschicht (52) getrennt ist.

8. Diodenschaltung nach Anspruch 7,
bei der der Induktor folgende Merkmale aufweist:
zumindest eine Windung;
einen ersten Anschluß, der mit einem Ende der Windung verbunden ist;
einem zweiten Anschluß, der mit einem anderen Ende der Windung verbunden ist,
wobei die Windung als leitfähiger Bereich in einer Schicht (58, 54) ausgebildet ist, die bezüglich der Hauptoberflache des Halbleiter-Substrats über der zumindest einen Isolatorschicht (40) angeordnet ist, durch die der Induktor von dem Halbleiter-Substrat (20) getrennt ist.

9. Diodenschaltung nach einem der Ansprüche 1 bis 8,
bei der das Halbleiter-Substrat ein hochohmiges Grundsubstrat (30) aufweist, das eine Hauptoberfläche aufweist, an der die zweite Halbleiter-Schicht (32) angeordnet ist.

10. Diodenschaltung nach einem der Ansprüche 1 bis 9, die ferner eine Verdrahtungsebene (48) aufweist, wobei die Verdrahtungsebene durch zumindest eine Isolatorschicht (40) von der Hauptoberfläche des Halbleiter-Substrats (20) getrennt ist,
wobei die Verdrahtungsebene Leiterbahnen innerhalb einer weiteren Isolatorschicht auf der zumindest einen Isolatorschicht aufweist.

11. Diodenschaltung nach einem der vorhergehenden Ansprüche, die als integrierte Schaltung ausgeführt ist und folgende Merkmale aufweist:
einen HF-Eingangsanschluß (3) für ein HF-Eingangssignal;
einen HF-Ausgangsanschluß (4) für ein HF-Ausgangssignal;
einen Steuerungsanschluß (1) zum Anlegen einer Versorgungsspannung an die erste Kontaktierung oder die zweite Kontaktierung;
einen Masseanschluß (2) zum Anlegen eines Massepotentials an die zweite bzw. erste Kontaktierung;
einen integrierten Widerstand (R1) zwischen dem Steuerungsanschluß (1) und einem Zwischenknoten;
einen ersten integrierten Induktor (L1) zwischen dem Zwischenknoten und der ersten Kontaktierung;
einen ersten integrierten Kondensator (C1) zwischen dem Zwischenknoten und dem Masseanschluß (2);
einen zweiten integrierten Kondensator (C2) zwischen dem HF-Eingangsanschluß (3) und der ersten Kontaktierung..

12. Diodenschaltung nach einem der Ansprüche 1 bis 11, bei der ferner ein weiterer Induktor (L3) und in Serie zu dem weiteren Induktor ein weiterer Kondensator (C4) zwischen die erste und die zweite Kontaktierung geschaltet ist,
wobei der weitere Induktor (L3) so dimensioniert ist, daß er mit einer Sperrkapazität bei einer Sperrpolung zwischen der ersten und der zweiten Halbleiter-Schicht einen Resonanzkreis bildet, der eine Resonanzfrequenz hat, die in der Nähe einer Betriebsfrequenz der an einem HF-Eingangsanschluß (3) anliegenden Hochfrequenzspannung liegt.

13. Diodenschaltung nach Anspruch 11 oder 12,
bei der ferner eine weitere Induktivität (L2) zwischen der zweiten Kontaktierung und dem Masseanschluß (2) angeordnet ist,
bei der ferner ein weiterer Widerstand (R2) zwischen die zweite Halbleiter-Schicht und den Masseanschluß (2) geschaltet ist; und/oder
bei der ferner ein weiterer Kondensator (C3) zwischen den weiteren Widerstand (R2) und den HF-Ausgangsanschluß (4) geschaltet ist.

14. Verfahren zum Herstellen einer Diodenschaltung, mit folgenden Schritten:
Bereitstellen eines Halbleiter-Substrats mit einer Hauptoberfläche, wobei das Halbleiter-Substrat folgende Merkmale aufweist:
eine erste Halbleiter-Schicht (36) mit einem ersten Dotierungstyp (p);
eine zweite Halbleiter-Schicht (32) mit einem zweiten Dotierungstyp (n), und
eine dritte Halbleiter-Schicht (34), die zwischen der ersten und der zweiten Halbleiter-Schicht angeordnet ist, und deren Konzentration an freien Ladungsträgern kleiner als eine Konzentration an freien Ladungsträgern der ersten und der zweiten Halbleiter-Schicht ist,
wobei die zweite Halbleiter-Schicht (32) eine in dem Halbleiter-Substrat (20) vergrabene Schicht ist,
wobei die erste Halbleiter-Schicht (36) an der Hauptoberfläche des Halbleiter-Substrats (20) angeordnet ist;
Herstellen einer ersten Kontaktierung (38) zum Kontaktieren der ersten Halbleiter-Schicht (36), die an der Oberfläche des Halbleiter-Substrats angeordnet ist; und
Herstellen einer zweiten Kontaktierung (44, 46) zum Kontaktieren der zweiten Halbleiter-Schicht (32), wobei sich die Kontaktierung von der Hauptoberfläche des Halbleiter-Substrats (20) bis zu der zweiten Halbleiter-Schicht (32) erstreckt, wobei der Schritt des Herstellens der zweiten Kontaktierung folgende Schritte aufweist:
Bilden eines Grabens durch zumindest einen Teil der dritten Halbleiter-Schicht (34);
Dotieren einer Umgebung (44) des Grabens, um einen dotierten Bereich (44) in der Umgebung des Grabens zu erzeugen, der sich bis zu der zweiten Halbleiter-Schicht (32) erstreckt; und
Isolieren einer Oberfläche des Grabens mittels einer Isolationsschicht und Füllen des Grabens mit einem leitfähigen Material.

15. Verfahren nach Anspruch 14,
bei dem der Schritt des Bereitstellens des Halbleiter-Substrats folgende Teilschritte aufweist:
Bereitstellen eines hochohmigen Grund-Halbleitersubstrats (30);
Dotieren eines Bereichs des hochohmigen Grund-Halbleitersubstrats, um die zweite Halbleiterschicht (32) zu erzeugen;
Aufbringen eines niederohmigen Bereichs (34) auf der zweiten Halbleiter-Schicht (32), um die dritte Halbleiter-Schicht . (34) zu erzeugen; und
Dotieren eines Bereichs in der dritten Halbleiter-Schicht (34), um die erste Halbleiter-Schicht (36) zu erzeugen.

16. Verfahren nach Anspruch 14 oder 15, bei dem im Schritt des Herstellens der zweiten Kontaktierung gleichzeitig ein Kondensatorgraben in der dritten Halbleiter-Schicht erzeugt wird.

## Claims

1. Diode circuit comprising:
a semiconductor substrate having a main surface, wherein the semiconductor substrate comprises:
a first semiconductor layer (36) of a first doping type (p);
a second semiconductor layer (32) of a second doping type (n); and
a third semiconductor layer (34) disposed between the first and the second semiconductor layer, the concentration of free charge carriers of which is smaller than a concentration of free charge carriers of the first and the second semiconductor layer,
wherein the second semiconductor layer (32) is a layer buried into the semiconductor substrate (20),
wherein the first semiconductor layer (36) is disposed on the main surface of the semiconductor substrate (20);
wherein a trench is present in the third semiconductor layer (34), the trench extending from the main surface of the semiconductor substrate at least partially to the second semiconductor layer (32),
a first contacting (38) for contacting the first semiconductor layer (36) arranged on the main surface of the semiconductor substrate; and
a second contacting (44, 46) for contacting the second semiconductor layer (32), wherein the second contacting extends from the main surface of the semiconductor substrate (20) to the second semiconductor layer (32),
wherein the second contacting (44, 46) includes a heavily doped area (44) in the third semiconductor layer (34), the area being spatially arranged around the trench in the third semiconductor layer (34), and
wherein the trench is insulated from the heavily doped area (44) by an isolator layer (64).

2. Diode circuit according to claim 1, further comprising:
an insulation trench (50) extending from the main surface of the semiconductor substrate to the buried layer (32) and essentially surrounding the first semiconductor layer (36) arranged on the main surface of the semiconductor substrate;
wherein the second contacting (44, 46) is arranged outside the insulation trench (50) and extends through the second semiconductor layer (34).

3. Diode circuit according to one of the preceding claims,
further comprising a capacitor integrated in the semiconductor substrate comprising a first electrode (60a, 60b) and a second electrode (62) which are both arranged on the main surface of the semiconductor substrate (20).

4. Diode circuit according to claim 3, wherein the capacitor further comprises:
a further trench in the third semiconductor layer (34);
a doped area (65) in the third semiconductor layer (34) arranged around the trench;
an isolator layer (64) in the further trench;
a conductive material on the insulation layer in the trench,
wherein the first electrode is connected to the conductive material in the further trench, and
wherein the second electrode is connected to the doped area (65) disposed around the further trench.

5. Diode circuit according to one of claims 1 to 4,
further comprising an integrated resistor (70) separated from the semiconductor substrate (20) by an isolator layer (42) on the main surface of the semiconductor substrate and comprising an area (70) made of an electrically conductive material.

6. Diode circuit according to claim 5, wherein the area made of an electrically conductive material comprises a material which is the same as a material in a trench of a capacitor provided in the third semiconductor layer (34) or as a material in a trench which is used for the second contacting.

7. Diode circuit according to one of the preceding claims,
further comprising an integrated inductor (16) separated from the semiconductor substrate by at least one isolator layer (52).

8. Diode circuit according to claim 7,
wherein the inductor comprises:
at least one turn;
a first terminal connected to an end of the turn;
a second terminal connected to another end of the turn,
wherein the turn is formed as a conductive area in a layer (58, 54) which, in relation to the main surface of the semiconductor substrate, is arranged above the at least one isolator layer (40) by which the inductor is separated from the semiconductor substrate (20).

9. Diode circuit according to one of claims 1 to 8,
wherein the semiconductor substrate comprises a high-resistance base substrate (30) comprising a main surface on which the second semiconductor layer (32) is disposed.

10. Diode circuit according to one of claims 1 to 9, further comprising a wiring level (48), wherein the wiring level is separated from the main surface of the semiconductor substrate (20) by at least one isolator layer (40),
wherein the wiring level comprises conductive traces within another isolator layer on the at least one isolator layer.

11. Diode circuit according to one of the preceding claims formed as an integrated circuit and comprising:
an HF input terminal (3) for an HF input signal;
an HF output terminal (4) for an HF output signal;
a control terminal (1) for applying a supply voltage to the first contacting or the second contacting;
a ground terminal (2) for applying a mass potential to the second or first contacting, respectively;
an integrated resistor (R1) between the control terminal (1) and an intermediate node;
a first integrated inductor (L1) between the intermediate node and the first contacting;
a first integrated capacitor (C1) between the intermediate node and the ground terminal (2);
a second integrated capacitor (C2) between the HF input terminal (3) and the first contacting.

12. Diode circuit according to one of claims to 11, wherein another inductor (L3) and, in series to the further inductor, another capacitor (C4) are connected between the first and the second contacting,
wherein the further inductor (L3) is sized such that it forms a resonance circuit with a cutoff capacity with a reverse-biasing between the first and the second semiconductor layer, the resonance circuit having a resonance frequency which is close to an operating frequency of the high-frequency voltage applying at an HF input terminal (3).

13. Diode circuit according to claim 11 or 12,
wherein further another inductivity (L2) is disposed between the second contacting and the ground terminal (2),
wherein further another resistor (R2) is connected between the second semiconductor layer and the ground terminal (2); and/or
wherein further another capacitor (C3) is connected between the further resistor (R2) and the HF output terminal (4).

14. Method of producing a diode circuit, comprising the following steps:
providing a semiconductor substrate having a main surface, wherein the semiconductor substrate comprises:
a first semiconductor layer (36) of a first doping type (p);
a second semiconductor layer (32) of a second doping type (n); and
a third semiconductor layer (34) disposed between the first and the second semiconductor layer, the concentration of free charge carriers of which is smaller than a concentration of free charge carriers of the first and the second semiconductor layer,
wherein the second semiconductor layer (32) is a layer buried into the semiconductor substrate (20),
wherein the first semiconductor layer (36) is disposed on the main surface of the semiconductor substrate (20);
producing a first contacting (38) for contacting the first semiconductor layer (36) arranged on the surface of the semiconductor substrate; and
producing a second contacting (44, 46) for contacting the second semiconductor layer (32), wherein the contacting extends from the main surface of the semiconductor substrate (20) to the second semiconductor layer (32), wherein the step of producing the second contacting comprises the following steps:
forming a trench through at least a part of the third semiconductor layer (34);
doping an environment (44) of the trench to produce a doped region (44) in the environment of the trench extending to the second semiconductor layer (32); and
insulating a surface of the trench by means of an insulation layer and filling the trench with a conductive material.

15. Method according to claim 14,
wherein the step of providing the semiconductor substrate comprises the following substeps:
providing a high-resistance base semiconductor substrate (30);
doping an area of the high-resistance base semiconductor substrate to produce the second semiconductor layer (32);
depositing a low-resistance area (34) on the second semiconductor layer (32) to produce the third semiconductor layer (34); and
doping an area in the third semiconductor layer (34) to produce the first semiconductor layer (36).

16. Method according to claim 14 or 15, wherein in the step of producing the second contacting, a capacitor trench is at the same time produced in the third semiconductor layer.

## Revendications

1. Circuit de diode, aux caractéristiques suivantes:
un substrat à semi-conducteur avec une surface principale, le substrat à semi-conducteur présentant les caractéristiques suivantes:
une première couche à semi-conducteur (36) avec un premier type de dopage (p);
une deuxième couche à semi-conducteur (32) avec un deuxième type de dopage (n), et
une troisième couche à semi-conducteur (34), disposée entre la première et la deuxième couche à semi-conducteur et dont la concentration de porteurs de charge est inférieure à une concentration de porteurs de charge de la première et la deuxième couche à semi-conducteur,
la deuxième couche à semi-conducteur (32) étant une couche enterrée dans le substrat à semi-conducteur (20),
la première couche à semi-conducteur (36) étant disposée à la surface principale du substrat à semi-conducteur (20);
dans la troisième couche à semi-conducteur étant présent un fossé (34) qui s'étend de la surface principale du substrat à semi-conducteur au moins partiellement jusqu'à la deuxième couche à semi-conducteur (32),
une première interconnexion (38) destinée à interconnecter la première couche à semi-conducteur (36) disposée à la surface principale du substrat à semi-conducteur; et
une deuxième interconnexion (44, 46) destinée à interconnecter la deuxième couche à semi-conducteur (32), la deuxième interconnexion s'étendant de la surface principale du substrat à semi-conducteur (20) jusqu'à la deuxième couche à semi-conducteur (32),
la deuxième interconnexion (44, 46) comportant une zone hautement dopée (44), située dans la troisième couche à semi-conducteur (34), qui est disposée spatialement autour du fossé dans la troisième couche à semi-conducteur (34), et
le fossé étant isolé de la zone hautement dopée (44) par une couche isolante (64).

2. Circuit de diode selon la revendication 1, présentant par ailleurs la caractéristique suivante:
un fossé isolant (50) qui s'étend de la surface principale du substrat à semi-conducteur jusqu'à la couche enterrée (32) et qui entoure substantiellement la première couche à semi-conducteur (36) disposée à la surface principale du substrat à semi-conducteur;
la deuxième interconnexion (44, 46) étant disposée en dehors du fossé isolant (50) et s'étendant à travers la deuxième couche à semi-conducteur (34).

3. Circuit de diode selon l'une des revendications précédentes,
qui présente par ailleurs un condensateur, intégré dans le substrat à semi-conducteur, présentant une première électrode (60a, 60b) et une deuxième électrode (62) qui sont toutes deux disposées à la surface principale du substrat à semi-conducteur (20).

4. Circuit de diode selon la revendication 3, dans lequel le condensateur présente par ailleurs les caractéristiques suivantes:
un autre fossé dans la troisième couche à semi-conducteur (34);
une zone dopée (65) dans la troisième couche à semi-conducteur (34), qui est disposée autour de l'autre fossé;
une couche isolante (64) dans l'autre fossé;
un matériau conducteur sur la couche isolante dans le fossé,
la première électrode étant reliée au matériau conducteur dans l'autre fossé, et
la deuxième électrode étant reliée à la zone dopée (65) qui est disposée autour de l'autre fossé.

5. Circuit de diode selon l'une des revendications 1 à 4,
qui présente par ailleurs une résistance intégrée (70) qui est séparée du substrat à semi-conducteur (20) par une couche isolante (42) sur la surface principale du substrat à semi-conducteur, et qui présente une zone (70) en matériau électroconducteur.

6. Circuit de diode selon la revendication 5, la zone en matériau électroconducteur présentant un matériau qui est le même qu'un matériau dans un fossé d'un condensateur qui est prévu dans la troisième couche à semi-conducteur (34), ou qu'un matériau dans un fossé qui est utilisé pour la deuxième interconnexion.

7. Circuit de diode selon l'une des revendications précédentes,
qui présente par ailleurs un inducteur intégré (16) qui est séparé du substrat à semi-conducteur par au moins une couche isolante (52).

8. Circuit de diode selon la revendication 7,
dans lequel l'inducteur présente les caractéristiques suivantes:
au moins un enroulement;
une première connexion qui est reliée à une extrémité de l'enroulement;
une deuxième connexion qui est reliée à une autre extrémité de l'enroulement,
l'enroulement étant réalisé sous forme de zone conductrice dans une couche (58, 54) qui est disposée, par rapport à la surface principale du substrat à semi-conducteur, au-dessus de l'au moins une couche isolante (40) par laquelle l'inducteur est séparée du substrat à semi-conducteur (20).

9. Circuit de diode selon l'une des revendications 1 à 8,
dans lequel le substrat à semi-conducteur présente un substrat de base hautement ohmique (30) présentant une surface principale à laquelle est disposée la deuxième couche à semi-conducteur (32).

10. Circuit de diode selon l'une des revendications 1 à 9, présentant par ailleurs un plan de câblage (48), le plan de câblage étant séparé par au moins une couche isolante (40) de la surface principale du substrat à semi-conducteur (20),
le plan de câblage présentant des chemins de conducteurs dans une autre couche isolante sur l'au moins une couche isolante.

11. Circuit de diode selon l'une des revendications précédentes, réalisé sous forme de circuit intégré et présentant les caractéristiques suivantes:
une connexion d'entrée HF (3) pour un signal d'entrée HF;
une connexion d'entrée HF (4) pour un signal de sortie HF;
une connexion de commande (1) destinée à appliquer une tension d'alimentation à la première interconnexion ou la deuxième interconnexion;
une connexion de masse (2) destinée à appliquer un potentiel de masse à la deuxième ou la première interconnexion;
une résistance intégrée (R1) entre la connexion de commande (1) et un noeud intermédiaire;
un premier inducteur intégré (L1) entre le noeud intermédiaire et la première interconnexion;
un premier condensateur intégré (C1) entre le noeud intermédiaire et la connexion de masse (2);
un deuxième condensateur intégré (C2) entre la connexion d'entrée HF (3) et la première interconnexion.

12. Circuit de diode selon l'une des revendications 1 à 11, dans lequel est par ailleurs connecté un autre inducteur (L3) et, en série avec l'autre inducteur, un autre condensateur (C4) entre la première et la deuxième interconnexion,
l'autre inducteur (L3) étant dimensionné de sorte qu'il forme avec une capacité de blocage à une polarité de blocage entre la première et la deuxième couche à semi-conducteur, une résonance ayant une fréquence de résonance qui est proche d'une fréquence de fonctionnement de la tension haute fréquence présente à une connexion d'entrée HF (3).

13. Circuit de diode selon la revendication 11 ou 12,
dans lequel une autre inductance (L2) est disposée entre la deuxième interconnexion et la connexion de masse (2),
dans lequel une autre résistance (R2) est connectée entre la deuxième couche à semi-conducteur et la connexion de masse (2); et/ou
dans lequel un autre condensateur (C3) est connecté entre l'autre résistance (R2) et la connexion de sortie HF (4).

14. Procédé pour fabriquer un circuit de diode, aux étapes suivantes consistant à:
préparer un substrat à semi-conducteur avec une surface principale, le substrat à semi-conducteur présentant les caractéristiques suivantes:
une première couche à semi-conducteur (36) avec un premier type de dopage (p);
une deuxième couche à semi-conducteur (32) avec un deuxième type de dopage (n), et
une troisième couche à semi-conducteur (34), disposée entre la première et la deuxième couche à semi-conducteur et dont la concentration de porteurs de charge est inférieure à une concentration de porteurs de charge de la première et la deuxième couche à semi-conducteur,
la deuxième couche à semi-conducteur (32) étant une couche enterrée dans le substrat à semi-conducteur (20),
la première couche à semi-conducteur (36) étant disposée à la surface principale du substrat à semi-conducteur (20);
réaliser une première interconnexion (38) destinée à interconnecter la première couche à semi-conducteur (36) disposée à la surface principale du substrat à semi-conducteur; et
réaliser une deuxième interconnexion (44, 46) destinée à interconnecter la deuxième couche à semi-conducteur (32), l'interconnexion s'étendant de la surface principale du substrat à semi-conducteur (20) jusqu'à la deuxième couche à semi-conducteur (32), l'étape consistant à réaliser la deuxième interconnexion présentant les étapes suivantes consistant à:
réaliser un fossé à travers au moins une partie de la troisième couche à semi-conducteur (34),
doper un environnement (44) du fossé, pour générer une zone dopée (44) dans l'entourage du fossé, laquelle s'étend jusqu'à la deuxième couche à semi-conducteur (32); et
isoler une surface du fossé au moyen d'une couche isolante et remplir le fossé d'un matériau conducteur.

15. Procédé selon la revendication 14,
dans lequel l'étape consistant à préparer le substrat à semi-conducteur présente les étapes partielles suivantes:
préparer un substrat à semi-conducteur de base hautement ohmique (30);
doper une zone du substrat à semi-conducteur de base hautement ohmique, pour générer la deuxième couche à semi-conducteur (32);
appliquer une zone faiblement ohmique (34) sur la deuxième couche à semi-conducteur (32), pour générer la troisième couche à semi-conducteur (34); et
doper une zone dans la troisième couche à semi-conducteur (34), pour générer la première couche à semi-conducteur (36).

16. Procédé selon la revendication 14 ou 15, dans lequel est généré, à l'étape consistant à réaliser la deuxième interconnexion, simultanément un fossé de condensateur dans la troisième couche à semi-conducteur.
